# EUROPEAN PATENT SPECIFICATION

(11) **EP 4 372 131 B1**
(45) Date of publication and mention of the grant of the patent: **03.12.2025**
(21) Application number: 22857837.3
(22) Date of filing: 17.08.2022
(51) Int. Cl.: C30B 35/00, F27D 21/02, F27B 5/06

(54) **WINDOW APPARATUS FOR OVEN BODY**
FENSTERVORRICHTUNG FÜR OFENKÖRPER
APPAREIL DE FENÊTRE POUR CORPS DE FOUR

(30) Priority: 17.08.2021 CN 202110942349
(43) Date of publication of application: 22.05.2024
(73) Proprietor: MEISHAN BOYA ADVANCED MATERIALS CO., LTD., Meishan, Sichuan 620010 (CN)
(72) Inventor: WANG, Yu, Meishan, Sichuan 620010 (CN); GU, Peng, Meishan, Sichuan 620010 (CN); LI, Min, Meishan, Sichuan 620010 (CN); LIANG, Zhenxing, Meishan, Sichuan 620010 (CN)
(74) Representative: Wang, Bo
(86) International application number: PCT/CN2022/112969
(87) International publication number: WO 2023/020526

(56) References cited:
- CN-A- 102 978 712
- CN-A- 102 978 712
- CN-A- 106 381 524
- CN-A- 108 179 479
- CN-A- 113 564 721
- CN-U- 206 204 481
- CN-U- 207 109 157
- CN-U- 208 545 515
- CN-Y- 2 844 146
- JP-A- H09 110 581

## Description

### CROSS REFERENCE TO RELATED APPLICATIONS

The present disclosure claims priority to Chinese Application No. 202110942349.7, filed on August 17, 2021.

### TECHNICAL FIELD

The present disclosure relates to the technical field of crystal preparation, and the present invention relates to a window device for a furnace.

### BACKGROUND

While using a furnace (e.g., an industrial furnace), a window is generally placed on a side of the furnace which facilitates an operator to monitor the condition in the furnace and to perform a corresponding operation. While the furnace is in use, some molten materials or gases inside the furnace may volatilize and stick to the inner side of the window, thus obscuring the operator's view through the window. Therefore, there is a need to provide a window device for a furnace that eases observation of the situation inside the furnace.

CN206204481U relates to the field of semiconductor chip single crystal preparation technology, especially for the observation window used in a crystal growth furnace. CN102978712A relates to a structural design of a sapphire crystal growth furnace, in particular to an observation window. CN108179479A relates to the field of observation window technology, and in particular to a detachable air-cooled observation assembly.

### SUMMARY

The scope of the present invention is defined by independent claim 1, and further embodiments of the invention are specified in dependent claims 2-15.

### BRIEF DESCRIPTION OF THE DRAWINGS

The present disclosure will be further illustrated by way of exemplary embodiments, which will be described in detail by means of the accompanying drawings. These embodiments are not limiting, and in these embodiments, the same numbering denotes the same structure, wherein:
FIG. 1 is a schematic diagram illustrating an exemplary structure of a furnace comprising a window device according to some embodiments of the present disclosure;
FIG. 2 is a schematic diagram illustrating an exemplary structure of an outer side of the window device according to some embodiments of the present disclosure;
FIG. 3 is a schematic diagram illustrating an exemplary structure of an inner side of the window device according to some embodiments of the present disclosure;
FIG. 4 is a schematic diagram illustrating an exemplary structure of a wind direction adjusting plate according to some embodiments of the present disclosure;
FIG. 5A is a schematic diagram illustrating an exemplary top view of the window device according to some embodiments of the present disclosure;
FIG. 5B is a schematic diagram illustrating the window device blocking a volatile according to some embodiments of the present disclosure;
FIG. 6A is a schematic diagram illustrating an exemplary top view of the window device according to some more embodiments of the present disclosure;
FIG. 6B is a schematic diagram illustrating the window device blocking the volatile according to some other embodiments of the present disclosure;
FIG. 6C is a schematic diagram illustrating the window device blocking the volatile according to some other embodiments of the present disclosure;
FIG. 7 is a schematic diagram illustrating an exemplary top view of the window device according to some other embodiments of the present disclosure;
FIG. 8 is a schematic diagram illustrating an exemplary structure of a dust collector according to some embodiments of the present disclosure.

Markings in the figures denote as follows: 10 - furnace, 11 - furnace wall, 100 - window device, 110 - window, 120 - frame, 130 - air inlet, 131 - air intake port, 140 - water inlet, 150 - water outlet, 160 - air outlet, and 170 - wind direction adjusting plate, 171 - sub-plate, 172 - sub-plate, 180 - baffle plate, 180-1 - sub-baffle-plate, 180-2 - sub-baffle-plate, 180-3 - sub-baffle-plate, 181 - direction of an arrow, 190 - dust collector, 191 - inclined plate, 192 - inclined plate, 193 - inclined plate, 194 - inclined plate, 195 - inclined plate.

### DETAILED DESCRIPTION

In order to more clearly illustrate the technical solutions of the embodiments of the present disclosure, the accompanying drawings required to be used in the description of the embodiments are briefly described below. Obviously, the accompanying drawings in the following description are only some examples or embodiments of the present disclosure, and it is possible for a person of ordinary skill in the art to apply the present disclosure to other similar scenarios following these drawings without creative labor. Unless obviously obtained from the context or the context illustrates otherwise, the same numeral in the drawings refers to the same structure or operation.

It should be understood that the terms "system", "device", "unit" and/or "module" as used herein is a way to distinguish between different components, elements, parts, sections or assemblies at different levels. However, the words may be replaced by other expressions if other words accomplish the same purpose.

As shown in the present disclosure and in the claims, unless the context clearly suggests an exception, the words "a", "one", "an" and/or "the" do not refer specifically to the singular and may include the plural. Generally, the terms "including" and "comprising" suggest only the inclusion of clearly identified steps and elements that do not constitute an exclusive list, and the method or apparatus may also include other steps or elements.

Flowcharts are used in the present disclosure to illustrate operations performed by a system according to embodiments of the present disclosure. It should be appreciated that the preceding or following operations are not necessarily performed in an exact sequence. Instead, steps can be processed in reverse order or simultaneously. Also, it is possible to add other operations to these processes or remove a step or steps from them.

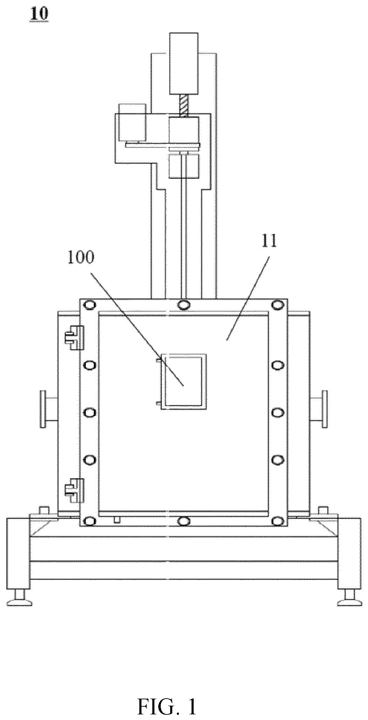

FIG. 1 is a schematic diagram illustrating an exemplary structure of a furnace comprising a window device according to some embodiments of the present disclosure.

In some embodiments, a furnace 10 may be used in metallurgy, chemicals, non-ferrous metals, building materials, machinery, light industry, and other industries. In some embodiments, the furnace 10 may be used to grow a crystal (e.g., sapphire, ruby, yttrium-aluminum garnet, gadolinium-gallium garnet, spinel, etc.), and, accordingly, the furnace 10 may include a crystal growth furnace (e.g., an induction furnace, a resistance furnace, etc.). In some embodiments, the furnace 10 may be used for smelting a metal (e.g., copper, iron, magnesium, aluminum, etc.), and accordingly, the furnace 10 may include a smelting furnace (e.g., a metal-smelting furnace, an ore-sintering furnace, a coke-forming furnace, etc.). In some embodiments, the furnace 10 may be used to produce light oil (e.g., gasoline, kerosene, diesel fuel, etc.), and accordingly, the furnace 10 may include a catalytic cracking furnace, a reforming heating furnace, a hydrocracking furnace, a hydro-refining reaction heating furnace, or the like. In some embodiments, the furnace 10 may be used to make coal gas, water gas, semi-water gas, etc., and accordingly, the furnace 10 may include a gas generator.

As shown in FIG. 1, a furnace chamber of the furnace 10 consists of a furnace wall 11 (i.e., a sidewall of the furnace) and a furnace bottom, and the furnace chamber of the furnace 10 may be a place for industrial production (e.g., crystal growth, metal smelting, chemical reactions). By controlling the furnace chamber of the furnace body 10 to be at a suitable temperature, air pressure, atmosphere, or the like, products of better quality (e.g., crystals, metals, light oils, gas) may be prepared.

In some embodiments, a window device 100 (or referred to as an observation window device) may be placed on the furnace wall 11 of the furnace 10. By placing the window device 100 on the furnace wall 11 of the furnace 10, it is made convenient for an operator to monitor situations inside the furnace in real time and perform a corresponding operation. For example, a crystal growth temperature is adjusted according to a shape and height of crystal growth to improve the quality of the crystal growth. For example, a reaction temperature is adjusted according to components of the light oil to adjust a percentage of different types of oil in the light oil.

In some embodiments, the connection of the window device 100 to the furnace wall 11 may be one or more of a bolted connection, a welded connection, a hinged connection, or a snap connection. In some embodiments, the frame of the window device 100 may be connected to the furnace wall 11 to realize the connection of the window device 100 to the furnace wall 11. In some embodiments, the frame of the window device 100 may be connected to the furnace wall 11 in one or more of a bolted connection, a welded connection, a hinged connection, or a snap connection.

In some embodiments, taking the crystal growth as an example, the material required for the crystal growth may be loaded into a crucible, and the crucible containing the material may be placed inside the furnace chamber of the furnace 10, and a crystal grows inside the furnace chamber of the furnace 10 by controlling the furnace chamber of the furnace 10 to be in a suitable temperature, air pressure, and atmosphere. During this process, the operator may observe the crystal growth inside the furnace chamber from the window device 100.

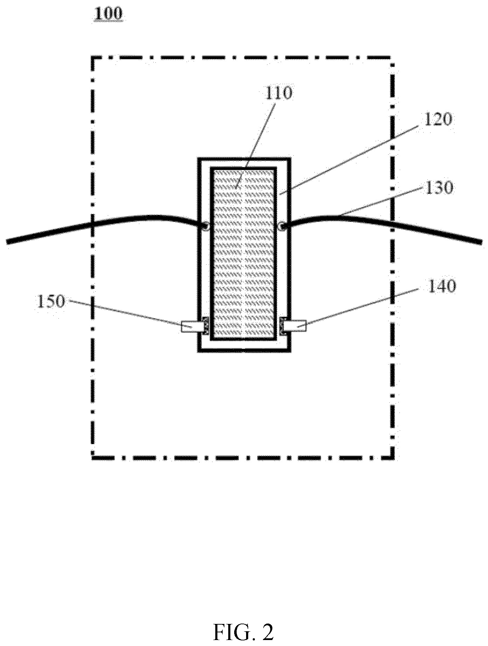

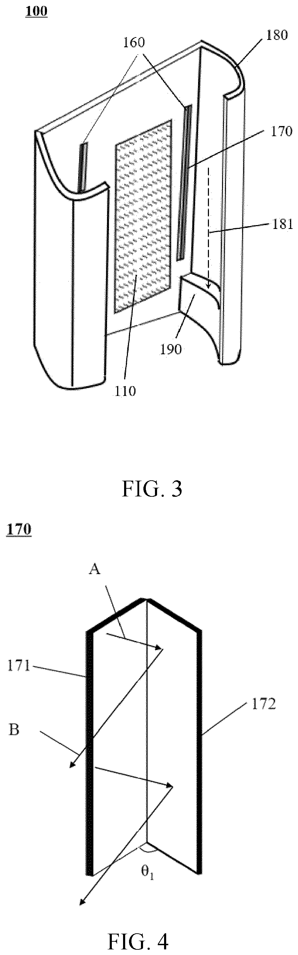

FIG. 2 is a schematic diagram illustrating an exemplary structure of an outer side of a window device according to some embodiments of the present disclosure; and FIG. 3 is a schematic diagram illustrating an exemplary structure of an inner side of a window device according to some embodiments of the present disclosure. The window device 100 provided by the embodiments of the present disclosure will be described in detail below in connection with FIG. 2 and FIG. 3. Following embodiments are merely for explaining the present disclosure and do not constitute a limitation of the present disclosure.

In some embodiments, as described in FIG. 2, the window device 100 may include a window 110 and a frame 120. In some embodiments, the window 110 may be placed on the frame 120. In some embodiments, a connection between the window 110 and the frame 120 may be one or more of a bolted connection, a welded connection, a hinged connection, or a snap connection. In some embodiments, the frame 120 may be placed on a sidewall of the furnace 10, such that one side of the frame 120 (or referred to as an outer side of the frame 120) is located outside the furnace in an outside environment; and the other side of the frame 120 (or referred to as an inner side of the frame 120) is located within the furnace in an industrial production environment within a furnace chamber.

In some embodiments, a planar shape of the window 110 may be one or more of a rectangular, circular, triangular, polygonal, and other regular or irregular shape. In some embodiments, the window 110 is transparent. In some embodiments, the window 110 may include glass, transparent ceramic, a wafer (e.g., a white gemstone wafer, a titanium gemstone wafer, a YAG wafer), or the like.

In some embodiments, a shape of an interior of the frame 120 may match the planar shape of the window 110. For example, the shape of the interior of the frame 120 is rectangular, the planar shape of the window 110 is also rectangular, and a planar dimension of the window 110 is enough to enable the window 110 to be embedded in the frame 120.

In some embodiments, the window device 100 may include at least one air inlet 130. In some embodiments, the at least one air inlet 130 may be placed on the frame 120. In some embodiments, the at least one air inlet 130 may be placed on the outer side of the frame 120. In some embodiments, a gas may be passed into the furnace through the at least one air inlet 130. In some embodiments, the gas that is passed through may be used to form a gas barrier in front of the window 110 and/or used to purge the window 110 which reduces or avoids deposition of volatiles in the window. In some embodiments, the gas may be a gas (e.g., oxygen, hydrogen, or a material gas) required for industrial production in the furnace. In some embodiments, the gas may also be other gases (e.g., inert gas). In some specific embodiments, during crystal growth, for crystals with ahigh melting point(e.g., a melting point is >1800° C.), for example, yttrium lutetium silicate (LYSO) scintillation crystals, yttrium aluminum garnet ( YAG) crystals or gadolinium-aluminum-gallium-garnet (GAGG) crystals, since an iridium crucible is usually used as a crystal growth furnace in a growth process of the crystals, to avoid oxidization of the iridium crucible in a high-temperature environment, one or more types of gas such as argon, nitrogen, carbon monoxide gas, hydrogen, carbon dioxide, or the like may be passed into the crystal growth furnace through the at least one air inlet 130. In yet further embodiments, during the crystal growth process, for crystals with a low melting point, air or an oxygen-containing gas may be passed into the crystal growth furnace through the at least one air inlet 130. In some embodiments, a gas component, gas pressure, gas flow rate, or the like of the gas being passed may be controlled according to a need of industrial production inside the furnace 10.

In some embodiments, the gas may be passed into the furnace 10 through two or more pipelines. For example, the gas passed through a first pipeline (e.g., the air inlet 130) into the furnace 10 is be primarily used to form a gas barrier or clear the window 110, and the gas required for industrial production is passed through a second pipeline or other pipelines (not shown in the figures) into the furnace 10. In some embodiments, the flow rate of the gas in the second pipeline or other pipelines may be greater than the flow rate of the gas in the first pipeline, such that the gas entering the furnace chamber through the first pipeline causes less perturbation to the production environment within the furnace chamber, thereby maintaining a stable production environment in the furnace chamber.

In some embodiments, the window device 100 may further include at least two air outlets 160. In some embodiments, the at least two air outlets 160 may be placed on the inner side of the frame 120 as shown in FIG. 3. In some embodiments, the at least two air outlets 160 may be connected with the air inlet 130 and the interior of the furnace 10. In some embodiments, a gas passed through the at least one inlet 130 may flow out of the at least two air outlets 160 into the interior of the furnace 10.

In the present invention, an angle of tangential directions of air venting pipelines at the at least two air outlets 160 are within a predetermined angle range. In some embodiments, the air venting pipelines at the at least two air outlets 160 may be an air venting pipeline at a connection with the air outlet 160. In the present invention, the tangential directions of the air venting pipelines at the at least two air outlets 160 are referred to as a direction in which a tangent line of the air venting pipeline follows a flow of an airflow (or referred to as an "airflow direction"). In some embodiments, a bend may be provided outside the at least two air outlets 160 to adjust the tangential direction of the air venting pipeline. In some embodiments, the tangential direction of the air venting pipeline at the air outlet 160 may be the same as an airflow direction at the air outlet 160.

In the present invention, the predetermined angle range is 10° to 170°. In some embodiments, the predetermined angle range may be 20° to 160°. In some embodiments, the predetermined angle range may be 30° to 150°. In some embodiments, the predetermined angle range may be 40° to 140°. In some embodiments, the predetermined angle range may be 50° to 130°. In some embodiments, the predetermined angle range may be 60° to 120°. In some embodiments, the predetermined angle range may be 70° to 120°. In some embodiments, the predetermined angle range may be 90° to 120°. In some embodiments, the predetermined angle range may be 95° to 110°.

In some embodiments, the at least two air outlets 160 may be respectively placed opposite to each other along a circumference of the window 110. In some embodiments, for example, when a shape of the window 110 is quadrilateral, the at least two air outlets 160 may include two air outlets placed on opposite sides (e.g., left and right sides, top and bottom sides) of the window 110. In some embodiments, the at least two air outlets 160 may include air outlets placed at the opposite positions along the circumference (e.g., up and down, left and right sides) of the window 110. In some embodiments, for example, when a shape of the window 110 is rounded or circular, the at least two air outlets 160 may include air outlets placed around the circumference of the window 110.

In some embodiments, the air outlet 160 may be elongated. In some embodiments, taking the air outlet 160 disposed on one side of the window 110 as an example, the air outlet 160 may be an elongated air outlet. In some embodiments, the air outlet 160 may be a plurality of elongated air outlets placed in parallel on one side of the window 110.

In some embodiments, if the air outlet 160 is a plurality of elongated air outlets placed in parallel on one side of the window 110, a space between two adjacent elongated air outlets (e.g., a shortest distance between an edge of one elongated air outlet and edge of an adjacent elongated air outlet) may be less than or equal to a first threshold. In some embodiments, the first threshold may be in a range of 1mm-10mm. In some embodiments, the first threshold may be in a range of 2mm-9mm. In some embodiments, the first threshold may be in a range of 3mm-8mm. In some embodiments, the first threshold may be in a range of 4mm-7mm. In some embodiments, the first threshold may be in a range of 5mm-6mm.

By providing the elongated air outlet, it is possible to cause the gas flowing out through the air outlet 160 in a form of a gas flow plane.

In some embodiments, the at least two air outlets 160 may be a single circular air outlet. In some embodiments, the air outlet 160 may be a set of circular air venting ports. In some embodiments, the set of circular air venting ports may be a row of circular air venting ports or a plurality of rows of circular air venting ports that are parallel to each other provided along one side of the window 110.

In some embodiments, if the set of circular air venting ports is a row of circular air venting ports placed along one side of the window 110, a space between two adjacent circular air venting ports in the row of circular air venting ports (e.g., a shortest distance between an edge of one circular venting port and an edge of another adjacent circular air venting port) may be less than or equal to a second threshold. In some embodiments, the second threshold may be in a range of 1mm-5mm. In some embodiments, the second threshold may be in a range of 2mm-4mm. In some embodiments, the second threshold may be in a range of 3mm-3.5mm.

In some embodiments, if the set of circular air venting ports is a plurality of rows of circular air venting ports that are parallel to each other placed along one side of the window 110, a space between two adjacent circular air venting ports in two adjacent rows (e.g., a shortest distance between an edge of one row of circular venting ports and an edge of another adjacent row of circular air venting ports) may be less than or equal to a third threshold. In some embodiments, the third threshold may be in a range of 1mm-10mm. In some embodiments, the third threshold may be in a range of 2mm-9mm. In some embodiments, the third threshold may be in a range of 3mm-8mm. In some embodiments, the third threshold may be in a range of 4mm-7mm. In some embodiments, the third threshold may be in a range of 5mm-6mm.

By providing the circular air outlet or the set of circular air venting ports, it is possible to cause the gas flowing out through the air outlet 160 in a form of an airflow plane formed by a single airflow bundle or a plurality of airflow bundles.

In some embodiments, the air outlet may be a single curved air outlet. In some embodiments, the air outlet may be a set of curved air outlets. In some embodiments, the set of curved air outlets may be a row of curved air outlets or a plurality of rows of curved air outlets that are parallel to each other placed along one side of the window 110.

In some embodiments, if the set of curved air outlets is a row of curved air outlets placed along one side of the window 110, a space between two adjacent air outlets in the row of curved air outlets (e.g., a shortest distance between an edge of one air outlet and an edge of another adjacent air outlet) may be less than or equal to a fourth threshold. In some embodiments, the fourth threshold may be in a range of 1mm-5mm. In some embodiments, the fourth threshold may be in a range of 2mm-4mm. In some embodiments, the fourth threshold may be in a range of 3mm-3.5mm.

In some embodiments, if the set of curved air outlets is a plurality of rows of curved air outlets that are parallel to each other placed along one side of the window 110, a space between two adjacent curved air outlets in two adjacent rows (e.g., a shortest distance between an edge of one row of curved air outlets and an edge of another adjacent row of curved air outlets) may be less than or equal to a fifth threshold. In some embodiments, the fifth threshold may be in a range of 1mm-10mm. In some embodiments, the fifth threshold may be in a range of 2mm-9mm. In some embodiments, the fifth threshold may be in a range of 3mm-8mm. In some embodiments, the fifth threshold may be in a range of 4mm-7mm. In some embodiments, the fifth threshold may be in a range of 5mm-6mm.

By providing the curved air outlet or the set of curved air outlets, it is possible to cause the gas flowing out through the air outlet 160 in a form of one or more curved airflow planes.

In some embodiments, a shape and/or distribution of the at least two air outlets 160 may be related to a shape of the window 110. In some embodiments, the shape and/or distribution of the at least two air outlets 160 may correlate with a shape of an outline of the window 110. For example, assuming that the shape of the outline of the window 110 is circular or elliptical, the at least two air outlets 160 may be a plurality of curved air outlets distributed along the circumference of the window 110; or the at least two air outlets 160 may be a plurality of circular air outlets which each set of circular air outlets may be a curved shape along the circumference. As another example, when the shape of the outline of the window 110 is triangular, rectangular, or polygonal, and the at least two air outlets 160 may be a plurality of elongated air outlets placed along a side length direction of the window 110.

In some embodiments, the at least two air outlets 160 may also be of any other suitable shape and/or distribution, e.g., quadrilateral, triangular, arcuate, irregularly shaped, etc. In some embodiments, the at least two air outlets 160 may be any suitable arrangement, e.g., parallel, spaced, crossed, circular, etc.

In some embodiments, two streams of gas flowing from the at least two air outlets 160 correspond to two airflow directions. In some embodiments, in conjunction with the above, since the angle of the tangential directions of air venting pipelines at the at least two air outlets is within the predetermined angle range, correspondingly, the two streams of gas flowing from the at least two air outlets 160 may intersect in a vicinity of the window 110 to form a gas barrier that prevents other gases or volatiles inside the furnace 10 (e.g., gases volatilized from a molten material) from adhering to a surface of the window 110, allowing an operator to have a clear view of the industrial production inside the furnace 10.

In some embodiments, as shown in FIG. 3, the window device 100 may further include at least two plates 170 for adjusting wind direction (also referred to as wind direction adjusting plate), and the at least two wind direction adjusting plates 170 may be placed outside each of the at least two air outlets 160, respectively. In some embodiments, the at least two wind direction adjusting plates 170 may be used to adjust the airflow direction of the gas flowing from the at least two air outlets 160. More about the wind direction adjustment plates 170 can be found in the relevant description of FIG. 4 and will not be repeated here.

In some embodiments, a dimension of the at least two air outlets 160 may be matched to a dimension of the window 110, so that the airflow surface flowing out of the air outlet 160 better protects the window 110. In some embodiments, a length of the at least two air outlets 160 may be greater than or equal to a length of the window 110, so that the airflow surface flowing out of the at least two air outlets 160 is greater than or equal to the length of the window 110, thereby better protecting the window 110.

In some embodiments, an airflow outputted by the air outlet 160 may be with a constant flow rate. By inputting the airflow with a constant flow rate, the chamber environment can be maintained stable for industrial production in a more stable reaction environment.

In some embodiments, the airflow outputted by the air outlet 160 may be in a form of a pulse. In some embodiments, the form of a pulse may be that the airflow is intermittent with high-flow output for a certain period of time and with low-flow steady output for the rest of the time. By introducing the gas in the form of a pulse, a flow rate or flow speed can be intermittently increased while a total amount of gas introduced remains constant to clear the window 110, thereby removing volatiles or other components adhered to the surface of the window 110.

In some embodiments, an air flow rate at the air outlet 160 may be adjusted based on an amount of volatiles. In some embodiments, at the beginning of the industrial production, the amount of volatiles is larger, and accordingly, the air flow rate may be set to a larger value. In some embodiments, after the industrial production has stabilized, the amount of volatiles becomes smaller, and accordingly, the air flow rate may be adjusted to a smaller value.

In some embodiments, a removable cover plate (not shown in the figures) may be provided over the at least two air outlets 160. In some embodiments, the opening and closing of the removable cover plate on the air outlet may be controlled to adjust the dimension of the air outlet 160 to adjust the air flow rate of the air outlet 160. In some embodiments, the opening and closing of the removable cover plate on each of at least a portion of the at least two air outlets 160 may also be controlled to ensure that the dimension and air flow rate of each of at least a portion of the at least two air outlets 160 are adjustable and an air flow rate of a remaining portion of the at least two air outlets 160 is fixed.

In some embodiments, returning to FIG. 2, the outer side of the frame 120 may be provided with a water inlet 140 and a water outlet 150. In some embodiments, the interior of the frame 120 may be hollow, and circulating cooling water flows into the frame 120 via the water inlet 140 and out of the frame 120 via the water outlet 150, forming a cooling channel across the window device 100. In some embodiments, a plurality of cooling channels may be provided in a hollow structure inside the frame 120, facilitating the circulating cooling water to circulate following a predetermined flow direction. In some embodiments, a plurality of baffles may be provided on the plurality of cooling channels inside the frame 120 to increase a degree of turbulence of the circulating cooling water and to increase an efficiency of the heat exchange, henceforth better cooling the window 110.

In the present invention, as shown in FIG. 3, the window device 100 includes at least two baffle plates 180.

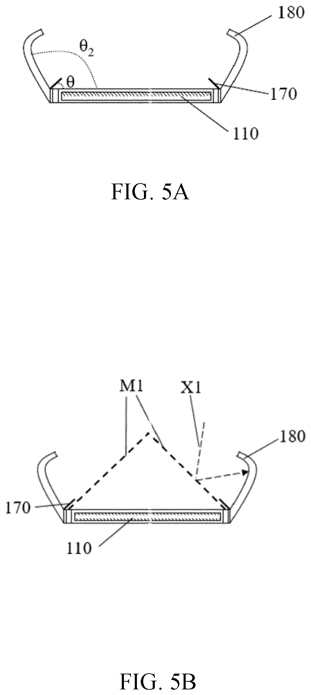

In some embodiments, the at least two baffle plates 180 may be placed along a circumference of the window 110 and outside the furnace, respectively. In the present invention, the at least two baffle plates 180 are placed outside the at least two air outlets 160, respectively. In some embodiments, an interior of one of the baffle plates 180 may be hollow and connected to the interior of the frame 120. In some embodiments, a plurality of cooling channels (not shown in the figures) may be provided in a hollow structure inside the one of the baffle plates 180, so that the circulating cooling water may also flow through an interior of the one of the baffle plates 180, then a temperature at a surface of the one of the baffle plates 180is lower than an internal temperature of the furnace chamber. More about the baffle plates 180 can be found in the relevant descriptions of FIG. 5A and FIG. 5B, which will not be repeated here.

In the persent invention, as shown in FIG. 3, the window device 100 further includes one or more dust collectors 190. In the present invention, one of the one or more dust collectors 190 placed below an inner side of one of the baffle plates 180 for collecting powder or other particulate matter that falls from an inner wall of the one of the baffle plates 180. In the present invention, a count of the dust collectors 190 is one or more. For example, only one dust collector may be provided, placed below the two baffle plates 180 and the window 110. Furthermore, for example, as shown in FIG. 3, two dust collectors 190 may be provided, placed below each of the two baffle plates 180, respectively.

In some embodiments, as the circulating cooling water flows through the interior of the baffle plates 180, the temperature at the surface of the baffle plates 180is lower than the internal temperature of the furnace chamber, and some volatiles inside the furnace chamber blocked by an outer sidewall of the baffle plates 180 may deposit on the outer sidewall of the baffle plates 180, to prevent powders deposited on the outer sidewall of the baffle plates 180 from falling into the furnace chamber again, the dust collector 190 (not shown in the figures) may also be provided below the outer sidewall of the baffle plate 180 for collecting the powders or other particulate matter that falls from the outer sidewall of the baffle 180.

In some embodiments, the dust collector 190 may be placed below the window 110 for collecting powders or other particulate matter falling from the window 110.

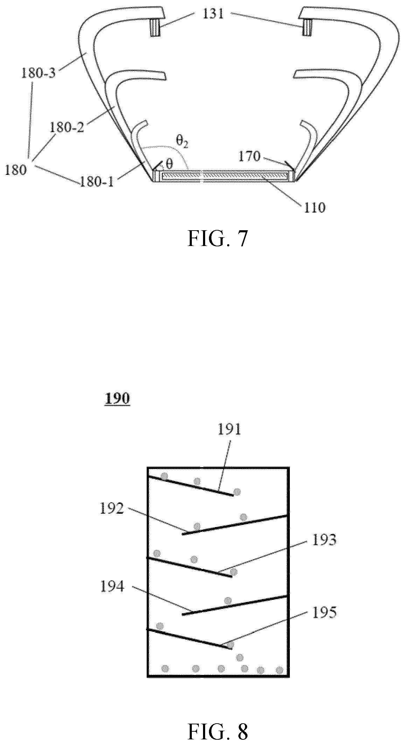

More content about the dust collector 190 can be found in the related description of FIG. 7, which will not repeated here.

FIG. 4 is a schematic diagram illustrating an exemplary structure of a wind direction adjusting plate according to some embodiments of the present disclosure.

In some embodiments, a wind direction adjusting plate 170 may include one or more sub-plates. The flow direction of a gas may be changed as a result of being blocked by the sub-plates, and accordingly, the flow direction of the gas (or referred to as an airflow direction) may be controlled by adjusting orientations of the sub-plates.

In some embodiments, when the wind direction adjusting plate 170 includes one single sub-plate (i.e., the wind direction adjusting plate 170 is a separate plate), the wind direction adjusting plate 170 may be mounted at an angle to the window 110. In some embodiments, a mounting manner of the wind direction adjusting plate 170 to the window 110 may be a movable connection (e.g., hinged). In some embodiments, an angle θ between the wind direction adjusting plate 170 and the window 110 may be adjustable.

In some embodiments, in order to ensure efficiency of the air outlet and stability of the gas barrier, and to prevent an outflowing gas from entering directly into an inner region of a furnace chamber and thus causing a temperature or temperature field inside the furnace to fluctuate, when the air outlet 160 and the wind direction adjusting plate 170 mounted on the frame 120, the angle θ between the wind direction adjusting plate 170 and the window 110 needs to be controlled within a certain range.

In some embodiments, the angle θ between the wind direction adjusting plate 170 and the window 110 may range from 10° to 65°. In some embodiments, the angle θ between the wind direction adjusting plate 170 and the window 110 may range from 15° to 60°. In some embodiments, the angle θ between the wind direction adjusting plate 170 and the window 110 may range from 20° to 55°. In some embodiments, the angle θ between the wind direction adjusting plate 170 and the window 110 may range from 25° to 50°. In some embodiments, the angle θ between the wind direction adjusting plate 170 and the window 110 may range from 30° to 45°. In some embodiments, the angle θ between the wind direction adjusting plate 170 and the window 110 may range from 35° to 40°. In some embodiments, the angle θ between the wind direction adjusting plate 170 and the window 110 may range from 38° to 40°.

In some embodiments, as shown in FIG. 4, the wind direction adjusting plate 170 may include two sub-plates, i.e., sub-plate 171 and sub-plate 172. In some embodiments, the sub-plate 171 may be provided with one or more air outlets (not shown in FIG. 4).

To make the air outlet applicable to scenarios with different demands, such as a scenario in which a flow rate of a gas is of a different magnitude, a scenario in which an air flow of the gas is of a different shape, a scenario in which the gas flow direction is of a different direction, etc., the wind direction adjusting plate 170 comprising two sub-plates is provided outside the air outlet 160, and a size and shape of the air outlets on the sub-plate 171 may be adjusted according to the demand.

In some embodiments, the air outlet on the sub-plate 171 may be matched to the air outlet 160, such that a gas, after passing through the air outlet 160, may flow out through the air outlets on the sub-plate 171. In some embodiments, the matching of the air outlets on the sub-plate 171 with the air outlet 160 may be such that the air outlets on the sub-plate 171 and the air outlet 160 are of the same or similar shape and/or distribution, and the air outlets on the sub-plate 171 and the air outlet 160 are different in dimensions within a certain threshold range (e.g., 3 mm).

In some embodiments, the air outlets on the sub-plate 171 may be elongated, or it may be adjusted to be a square, a round hole, or any shape according to an actual need to adjust a flow rate of gas at the air outlet.

In some embodiments, in conjunction with the foregoing, the air outlets on the sub-plate 171 may be a single elongated air outlet or a plurality of elongated air outlets provided in parallel.

In some embodiments, if the air outlets on the sub-plate 171 includes a plurality of elongated air outlets placed in parallel, a space between two adjacent elongated air outlets (e.g., a shortest distance between an edge of one elongated air outlet and an edge of adjacent elongated air outlet) on the sub-plate 171 may be less than or equal to a first threshold.

In some embodiments, in conjunction with the preceding, the air outlets on the sub-plate 171 may be circular. In some embodiments, the air outlets on the sub-plate 171 may be a single circular air venting port or a set of circular air venting ports (e.g., the set of circular air venting ports may be a single row of air venting ports or a set of multiple rows of air venting ports that are parallel to each other placed along a vertical direction of the sub-plate 171).

In some embodiments, if the set of circular air venting ports is arranged in a row along the vertical direction of the sub-plate 171, a space between two adjacent air venting ports in the row (e.g., a shortest distance between an edge of one air venting port and an edge of adjacent air venting port) on the sub-plate 171 may be less than or equal to a second threshold.

In some embodiments, if the set of circular air venting ports is arranged in multiple rows along the vertical direction of the sub-plate 171that are parallel to each other , a space between two adjacent air venting ports in adjacent rows (e.g., a shortest distance between an edge of a row of air venting ports and an edge of r adjacent row of air venting ports) may be less than or equal to a third threshold.

In some embodiments, in conjunction with the foregoing, the air outlets on the sub-plate 171 may be a single curved air outlet. In some embodiments, the air outlets on the sub-plate 171 may be a set of curved air outlets. In some embodiments, the set of curved air outlets may be a single row of curved air outlets or a set of multiple rows of curved air outlets that are parallel to each other placed along the vertical direction of the sub-plate 171.

In some embodiments, if the set of curved air outlets is arranged in a row of along the vertical direction of the sub-plate 171, a space between two adjacent air outlets in the row (e.g., a shortest distance between an edge of one air outlet and an edge of adjacent air outlet) on the sub-plate 171 may be less than or equal to a fourth threshold.

In some embodiments, if the set of curved air outlets is arranged in multiple rows along the vertical direction of the sub-plate 171 that are parallel to each other, a space between two adjacent curved air outlets in adjacent rows (e.g., a shortest distance between an edge of a row of curved air outlets and an edge of adjacent row of curved air outlets) may be less than or equal to a fifth threshold.

In some embodiments, an angle may be involved when mounting the sub-plate 171 and sub-plate 172. In some embodiments, the sub-plate 171 and sub-plate 172 may be mounted in a movable connection (e.g., hinged). In some embodiments, an angle θ₁ between the sub-plate 171 and the sub-plate 172 may be adjustable.

In some embodiments, in order to ensure the efficiency of the air outflow and the stability of the gas barrier, and to prevent the outflow gas from entering directly into the inner region of the furnace chamber and thus causing the temperature or temperature field inside the furnace to fluctuate, the angle θ₁ between the sub-plate 171 and the sub-plate 172 needs to be controlled within a certain range.

In some embodiments, the angle θ₁ between the sub-plate171 and the sub-plate172 may range from 10° to 65°. In some embodiments, the angle θ₁ between the sub-plate171 and the sub-plate172 may range from 15° to 60°. In some embodiments, the angle θ₁ between the sub-plate 171 and the sub-plate 172 may range from 20° to 55°. In some embodiments, the angle θ₁ between the sub-plate 171 and the sub-plate172 may range from 25° to 50°. In some embodiments, the angle θ₁ between the sub-plate 171 and the sub-plate 172 may range from 30° to 45°. In some embodiments, the angle θ₁ between the sub-plate 171 and the sub-plate 172 may range from 35° to 40°. In some embodiments, the angle θ₁ between the sub-plate 171 and the sub-plate 172 may range from 38° to 40°.

In some embodiments, after the wind direction adjusting plate 170 is mounted outside the air outlet 160, after flowing out of the air outlet 160, the gas flows out through the air outlets on the sub-plate 171 of the wind direction adjusting plate 170. As shown in FIG. 4, a flowing trajectory of the gas on the wind direction adjusting plate 170 may be as follows: a direction in which the gas flows out of the at least two air outlets on the sub-plate 171 is an airflow direction A, and under the blocking effect of the sub-plate 172, the direction in which the gas flows changes to an airflow direction B, and an angle between the airflow direction B and the window 110 is less than 90°. Correspondingly, using the wind direction adjustment by the at least two wind direction adjusting plates 170 placed outside the air outlets 160, respectively, at least two streams of gases flowing out of the air outlets 160 converge to form a gas barrier in the vicinity of the window 110 (i.e., a side of the window 110 facing the furnace chamber).

By setting the wind direction adjusting plate 170 and by setting the angle between the wind direction adjusting plate 170 (or a sub-plate of the wind direction adjusting plate 170) and the window 110 adjustable, the airflow direction in the vicinity of the window 110 can be effectively adjusted, so that the gas barrier formed by the at least two streams of gases can better prevent volatiles from adhering to the window 110 and ensure an observation effect of the window 110.

FIG. 5A is a schematic diagram illustrating an exemplary top view of a window device according to some embodiments of the present disclosure.

In some embodiments, a baffle plate 180 may be curved. In some embodiments, a cross-sectional shape of the baffle plate 180 may be a curved arc, as shown in FIG. 5A. In some embodiments, the baffle plate 180 may be fan-shaped. In some embodiments, the cross-sectional shape of the baffle plate 180 may also be fan-shaped or otherwise. In some embodiments, a cross-sectional length of the baffle 180 may be adjustable such that the baffle plate 180 has a telescoping function along a horizontal direction. By providing a curved or fan-shaped baffle plate, a gas flowing out of the air outlet 160 may enter a growth chamber more gently, which a stable industrial production environment inside a furnace chamber can be maintained.

In some embodiments, an angle between the baffle plate 180 and the window 110 is θ₂ as shown in FIG. 5A. In some embodiments, the angle θ₂ between the baffle plate 180 and the window 110 is adjustable.

In some embodiments, in order to prevent volatiles blocked by a gas barrier from re-entering an industrial production region inside the furnace and depositing on a surface of a product (e.g., crystals, metals), the angle θ₂ between the baffle plate 180 and the window 110 needs to be controlled within a certain range to allow the volatiles to be blocked by the baffle plate 180 and then collected by the dust collector 190.

In some embodiments, the angle θ₂ between the baffle plate 180 and the window 110 ranges from 30° to 90°. In some embodiments, the angle θ₂ between the baffle plate 180 and the window 110 ranges from 35° to 85°. In some embodiments, the angle θ₂ between the baffle plate 180 and the window 110 ranges from 40° to 80°. In some embodiments, the angle θ₂ between the baffle plate 180 and the window 110 ranges from 45° to 75°. In some embodiments, the angle θ₂ between the baffle plate 180 and the window 110 ranges from 50° to 70°. In some embodiments, the angle θ₂ between the baffle plate 180 and the window 110 ranges from 55° to 65°. In some embodiments, the angle θ₂ between the baffle plate 180 and the window 110 ranges from 58° to 63°. In some embodiments, the angle θ₂ between the baffle plate 180 and the window 110 ranges from 60° to 63°.

As described above, in order to ensure an efficiency of the air outlet and a stability of the gas barrier, and to prevent an outflowing gas from directly entering the industrial production area inside the furnace chamber and thereby causing a fluctuation in a temperature or the temperature field inside the furnace chamber, and to prevent volatiles blocked by the gas barrier from re-entering the industrial production area and depositing on the surface of the product, the angle θ₂ between the baffle plate 180 and the window 110, and the angle θ between the wind direction adjusting plate 170 and the window 110 (or the angle θ₁ between the sub-plate 171 with the sub-plate 172) need to satisfy a certain matching relationship. In some embodiments, a difference between the angle θ₂ between the baffle plate 180 and the window 110 and the angle θ between the wind direction adjusting plate 170 and the window 110 (or the angle θ₁ between the sub-plate171 and the sub-plate172) is less than or equal to a predetermined threshold (e.g., 40°), so that the efficiency of the air outlet of a gas from the wind direction adjusting plate 170 and the gas barrier are more stable, and the baffle plate 180 can prevent the outflowing gas from directly entering the industrial production area inside the furnace chamber which causes the fluctuation of the temperature or the temperature field inside the furnace chamber, and also prevent the volatiles blocked by the gas barrier from re-entering the industrial production area and depositing on the surface of the product. For example, when the angle θ between the wind direction adjusting plate 170 and the window 110 (or the angle θ₁ between the sub-plate 171 and the sub-plate 172) ranges from 10° to 65°, the angle θ₂ between the baffle plate 180 and the window 110 may range from 30° to 90°. As another example, when the angle θ between the wind direction adjusting plate 170 and the window 110 (or the angle θ₁ between the sub-plate 171 and the sub-plate 172) ranges from 20° to 40°, the angle θ₂ between the baffle plate 180 and the window 110 may range from 60° to 80°.

FIG. 5B is a schematic diagram illustrating a window device blocking a volatile according to some embodiments of the present disclosure.

As shown in FIG. 5B, a gas flowing from the air outlet 160, after being adjusted by the wind direction adjusting plate 170, forms a gas flow that has a certain angle to the window 110 in the vicinity of the window 110, and gas flowing on both sides of the window 110 converge to form a gas barrier M1 that block volatiles outside the gas barrier M1. When a volatile X1 moves toward the window 110, the volatile X1 moves away from the window 110 and moves towards the baffle plate 180 due to blocking effect of the gas barrier M1 on the volatile X1. Furthermore, due to blocked by the baffle plate 180, the kinetic energy of the volatile X1 decreases sharply (close to 0). At the same time, due to circulating cooling water passed inside the baffle plate 180, the volatile X1 is cooled rapidly. The cooled volatile X1 with a reduced kinetic energy falls into the dust collector 190 under an action of gravity, or the cooled volatile X1 with a reduced kinetic energy deposits on a sidewall of the baffle plate 180, and falls downwardly into the dust collector 190 under the action of gravity when a weight of the deposits reaches a certain value.

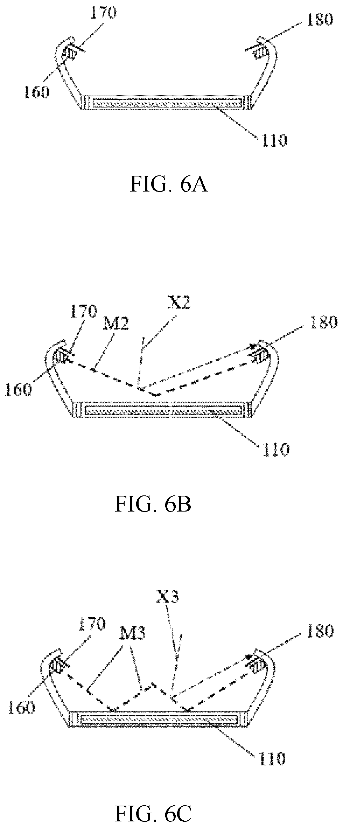

FIG. 6A is a schematic diagram illustrating an exemplary top view of a window device according to some other embodiments of the present disclosure.

In some embodiments, at least two air outlets 160 may be placed on at least two baffle plates 180, respectively. In some embodiments, as shown in FIG. 6A, each of the at least at least two air outlets 160 may be placed on an inner side of one of the at least two baffle plates 180 and face toward the window 110 (e.g., a tangential direction of an air venting pipeline or an airflow direction is toward the window 110).

In some embodiments, the at least two air outlets 160 may be placed opposite to each other along a vertical direction of the baffle plate 180 (along a direction of an arrow 181 as shown in FIG. 3). In some embodiments, the at least two air outlets 160 may comprise two air outlets placed opposite on both sides (e.g., left and right) of the baffle plate 180.

In some embodiments, the air outlet 160 may be provided on only one of the at least two baffle plates 180. The air outlet 160 may be provided on an inner side of the one of the at least two baffle plates 180 and face the window 110, and an airflow direction of the air outlet 160 crosses the other one of the at least two baffle plates 180 to allow the gas barrier to have a blocking effect on the window 110.

More content about the air outlet and the baffle plate can be found in the relevant descriptions of FIG. 2 and FIG. 3, which will not be repeated here.

In some embodiments, in conjunction with the foregoing, the window device 100 may further include at least two wind direction adjusting plates 170, and the at least two wind direction adjusting plates 170 may be placed on outside the at least two air outlets 160. More content about the wind direction adjusting plate 170 can be found in the relevant descriptions of FIGs. 2 to 4, which will not be repeated herein.

FIG. 6B is a schematic diagram illustrating a window device blocking a volatile according to some other embodiments of the present disclosure.

As shown in FIG. 6B, a gas flowing from the air outlet 160, after being adjusted by the wind direction adjusting plate 170, forms two gas streams that have a certain angle facing the window 110 in a vicinity of the window 110, and the two gas streams intersect to form a gas barrier M2, which can block a volatile outside the gas barrier M2. When a volatile X2 moves toward the window 110, the volatile X2 moves away from the window 110 or moves toward the baffle plate 180 due to a blocking effect of the gas barrier M2 on the volatile X2. Furthermore, the volatile X2 enters a furnace chamber after moving away from the window 110, and does not affect an observation of the window 110. Or, as a result of being blocked by the baffle plate 180, a kinetic energy of the volatile X2 is sharply reduced (close to 0), and as a result of circulating cooling water passed inside the baffle plate 180, the volatile X2 is cooled rapidly. The cooled volatile X2 with a reduced kinetic energy falls downward into the dust collector 190 under the action of gravity, or the cooled volatile X2 with a reduced kinetic energy deposits on a sidewall of the baffle plate 180 and falls downwardly into the dust collector 190 under the action of gravity when a weight of deposits reaches a certain value.

FIG. 6C is a schematic diagram illustrating a window device blocking a volatile according to some other embodiments of the present disclosure.

As shown in FIG. 6C, a gas flowing from the air outlet 160, after being adjusted by the wind direction adjusting plate 170, forms two gas streams blowing toward the window 110, and the two gas streams blow toward the window 110 to sweep volatiles adhered to the window 110. The two gas streams, after being reflected by the window 110, converge to form two gas streams with a certain angle and form a gas barrier M3 in front of the window 110 which can block the volatiles outside the gas barrier M3. When a volatile X3 moves toward the window 110, the volatile X3 moves away from the window 110 or moves towards the baffle plate 180 due to blocking effect of the gas barrier M3 on the volatile X3. Furthermore, the volatile X3 enters a furnace chamber after moving away from the window 110 and does not affect the observation of the window 110. Or, the kinetic energy of the volatile X3 decreases rapidly (close to 0) due to being blocked by the baffle plate 180, and the volatile X3 is cooled rapidly due to circulating cooling water passed inside the baffle plate 180. The cooled volatile X3 with a reduced kinetic energy falls downward into the dust collector 190 under the action of gravity, or the cooled volatile X3 with a reduced kinetic energy deposits on a sidewall of the baffle plate 180 and then falls downwardly into the dust collector 190 under the action of gravity when a weight of deposits reaches a certain value.

In some embodiments, an angle between the wind direction adjusting plate 170 and a tangent line of an air venting pipeline at the air outlet 160 may also be adjusted to adjust an airflow direction so that an air flow does not only have a clearing function but also can serve a gas barrier as shown in FIG. 6C. In some embodiments, in an early stage of industrial production, when an amount of volatiles is large, an airflow direction and gas flow rate may be adjusted so that the air flow has both a clearing function and can serve as a gas barrier as shown in FIG. 6C to clear the volatiles adhered to the window 110 and block volatiles from entering a vicinity of the window 110. In some embodiments, during stable industrial production, when the amount of volatiles is small, the airflow direction and gas flow rate may be adjusted so that the gas flow does not have a clearing function but only serves as a gas barrier to block volatiles from entering the vicinity of the window 110 as shown in FIG. 6B.

In some embodiments, an orientation and angle of the wind direction adjusting plate 170 may also be adjusted to adjust an orientation of a gas output from the air outlet 160 such that the gas flows out toward the window 110 downwardly to blow the volatiles off of the window 110 and make the volatiles directly fall into the dust collector below the window 110.

FIG. 7 is a schematic diagram illustrating an exemplary top view of a window device according to some other embodiments of the present disclosure.

In some embodiments, the baffle plate 180 may include a plurality of sub-baffle-plates. An angle between two of the plurality of sub-baffle-plates is adjustable. In some embodiments, as shown in FIG. 7, the baffle plate 180 may include a sub-baffle-plate 180-1, a sub-baffle-plate 180-2, and a sub-baffle-plate 180-3. In some embodiments, an angle between the sub-baffle-plate 180-1 and the sub-baffle-plate 180-2 is adjustable. In some embodiments, the angle between the sub-baffle-plate 180-2 and the sub-baffle-plate 180-3 is adjustable.

In some embodiments, the angle between the sub-baffle-plate 180-1 and the sub-baffle-plate 180-2 may be in a range of 0° to 30°. In some embodiments, the angle between the sub-baffle-plate 180-1 and the sub-baffle-plate 180-2 may be in a range of 5° to 25°. In some embodiments, the angle between the sub-baffle-plate 180-1 and the sub-baffle-plate 180-2 may be in a range of 10° to 20°. In some embodiments, the angle between the sub-baffle-plate 180-1 and the sub-baffle-plate 180-2 may be in a range of 15° to 18°.

In some embodiments, the angle between the sub-baffle-plate 180-2 and the sub-baffle-plate 180-3 may be in a range of 0° to 30°. In some embodiments, the angle between the sub-baffle-plate 180-2 and the sub-baffle-plate 180-3 may be in a range of 5° to 25°. In some embodiments, the angle between the sub-baffle-plate 180-2 and the sub-baffle-plate 180-3 may be in a range of 10° to 20°. In some embodiments, the angle between the sub-baffle-plate 180-2 and the sub-baffle-plate 180-3 may be in a range of 15° to 18°.

In some embodiments, the angle between two of the plurality of sub-baffle-plates is adjustable and a size of the angle may be determined based on an industrial production situation (e.g., an amount of volatiles). In some embodiments, if the amount of volatiles is large, the angle between any two of the sub-baffle-plate 180-1, sub-baffle-plate 180-2, and sub-baffle-plate 180-3 may be adjusted to be smaller so that the baffle plate 180 can have a better blocking effect. In some embodiments, the angle between any two of the sub-baffle-plate 180-1, the sub-baffle-plate 180-2, and the sub-baffle-plate 180-3 may be adjusted larger if the amount of volatiles is smaller.

In some embodiments, the baffle plate 180 may include a set of sub-baffle-plates with a telescopic function. In some embodiments, as shown in FIG. 7, each of the sub-baffle-plate 180-1, the sub-baffle-plate 180-2, and the sub-baffle-plate 180-2 may expand and contract.

In some embodiments, whether to use a sub-baffle-plate and a count of sub-baffle-plates to be used may be determined based on an industrial production situation (e.g., the amount of volatiles). In some embodiments, if the amount of volatiles is large, three sub-baffle-plates may be used and the sub-baffle-plate 180-1, sub-baffle-plate 180-2, and sub-baffle-plate 180-3 may extend for use. In some embodiments, if the amount of volatiles is moderate, two sub-baffle-plates may be used, and two sub-baffle-plates may extend for use, and the other sub-baffle-plate contracts. In some embodiments, if the amount of volatiles is small, only one sub-baffle-plate may be used, and one sub-baffle-plate 180-1 may extend for use and the other two sub-baffle-plates contract.

By providing the set of sub-baffle-plates in which the angle between two sub-baffle-plates being adjustable and/or the sub-baffle-plates with a telescoping function, a better blocking effect on volatiles can be achieved, and the angle between the sub-baffle-plates and/or a telescoping situation can be adjusted according to the amount of volatiles, thereby better blocking the volatiles.

In some embodiments, the window device 100 may further include at least one air intake port 131. In some embodiments, the at least one air intake port 131 may be provided on the baffle plate 180. In some embodiments, the at least one air intake port 131 may be placed on the sub-baffle-plate 180-3, as shown in FIG. 7. In some embodiments, the at least one air intake port 131 may also be placed on the sub-baffle-plate 180-1, the sub-baffle-plate 180-2, or the baffle plate 180 shown in FIGs. 5A to 6C, and the present disclosure places no limitations on a position of the air intake port 131. In some embodiments, the at least one air intake port 131 may be coupled to a pumping device (e.g., a pump) via a pipeline to pump an airflow from the air outlet 160.

Pumping the airflow out of the air outlet 160 through the air intake port 131 reduces an amount of air flow in a vicinity of the window 100, thereby reducing a disturbance of a blocking gas on an interior of a furnace chamber and maintaining a stable furnace chamber environment.

In some embodiments, an air intaking flow rate of the air intake port 131 may be less than or equal to an air discharging flow rate of the air outlet 160. By setting the air intaking flow rate of the air intake port 131 to be less than or equal to the discharging flow rate of the air outlet 160, on the one hand, a stable circulating airflow can be formed, the disturbance of the airflow on the interior of the furnace chamber can be reduced, and a stable furnace chamber is maintained, on the other hand, for a gas required for industrial production, some gases required for the industrial production can flow into the furnace chamber steadily for the industrial production to proceed smoothly.

FIG. 8 is a schematic diagram illustrating an exemplary structure of a dust collector according to some embodiments of the present disclosure.

In order to further prevent a volatile or other gases from floating out of the dust collector 190 into a furnace chamber again, in some embodiments, as shown in FIG. 8, at least two inclined plates may be provided inside the dust collector 190. Two adjacent inclined plates may be arranged inside the dust collector 190. In some embodiments, a count of the at least two inclined plates may be set according to an actual need. In some embodiments, the at least two inclined plates may be inclined downward.

In some embodiments, an angle at which one of the at least two adjacent inclined plates are inclined downward may be adjusted as appropriate. In some embodiments, the angle at which one of the inclined plates is inclined downward may range from 10° to 60°. In some embodiments, for example, the angle at which one of the inclined plates are inclined downward may range from 15° to 55°. In some embodiments, for example, the angle at which one of the inclined plates is inclined downward may range from 20° to 50°. In some embodiments, for example, the angle at which one of the inclined plates is inclined downward may range from 25° to 45°. In some embodiments, for example, the angle at which one of the inclined plates is inclined downward may range from 30° to 40°. In some embodiments, for example, the angle at which one of the inclined plates are inclined downward may range from 35° to 38°.

In some embodiments, a gap exists between the at least two adjacent inclined plates to allow dropped volatiles or other gaseous powders to fall into a bottom of the dust collector 190, avoiding a situation in which volatiles or other gaseous powders become stuck on a middle or upper part of the inclined plates.

As shown in FIG. 8, after falling into the dust collector 190, the volatiles or other gaseous powders fall onto an inclined plate 191 on a left side, slide down from the tilted inclined plate 191 onto an inclined plate 192 on a right side due to the effect of gravity, and then slides down in turn due to gravity to an inclined plate 193, an inclined plate 194, an inclined plate 195, and finally fall into the bottom of the dust collector 190. If an environment fluctuates or the powders are heated again, the powders may float again, and upward-floating powders may be blocked by lower surfaces of the inclined plate 195, the inclined plate 194, the inclined plate 193, the inclined plate 192, the inclined plate 191 in turn, and it is difficult for the powders to float upward out of the dust collector 190.

By providing a plurality of inclined plates arranged in a zigzag, volatiles or other gaseous powders can be avoided from getting stuck on middle or upper inclined plates, so that fallen volatiles or other gaseous powders can fall into the bottom of the dust collector 190, and also the powders can be prevented from floating out of the dust collector 190 into the furnace chamber again to some extent, which may float to a surface of a product to erode the product.

The following takes a crystal growth furnace for growing crystals as an example, illustrating a process of using the window device 100 mounted on a furnace in conjunction with FIGs. 2 to 8, and it is to be noted that the present embodiment is only used to illustrate the technical solution rather than to limit the technical solution. As shown in FIG. 2, a gas or an inert gas required for crystal growth is passed through the air inlet 130, and circulating cooling water is passed through the water inlet 140 and the water flows throughout an entire hollow structure of the frame 120 of the window device 100 (not shown in FIG. 2) and flows out of the water outlet 150. During a crystal growth process, some raw materials (e.g., Ga₂O₃ or SiO₂) on a surface of a molten material are volatile, and volatiles float randomly throughout a chamber, with some of the volatiles flowing into a vicinity of the window 110. As shown in FIGs. 3-4, 5A-5B, and 6A-6B, the gas or inert gas required for the crystal growth, which is passed through the air inlet 130, flows into the chamber through the air outlet 160, and under an adjusting effect of the wind direction adjusting plate 170, flowing gases converge in the vicinity of the window 110 to form a gas barrier. As shown in FIG. 5B, when a volatile is close to the gas barrier M1, the volatile X1 drifts to the baffle plate 180 and is blocked by the baffle plate 180, since the circulating cooling water is being passed into the baffle plate 180, a temperature at a surface of the baffle plate 180 is low, then the volatile X1 may fall downwardly along a direction of an arrow 181 into the dust collector 190 under action of gravity after being cooled. As shown in FIG. 6B, when the volatile is close to the gas barrier M2 as shown in FIG. 6B, under a blocking effect of the gas barrier M2, the volatile X2 drifts to the baffle plate 180 and is blocked by the baffle plate 180; since the circulating cooling water is being passed into the baffle plate 180, the temperature at the surface of the baffle plate 180 is low, then the volatile X2 may fall downwardly along the direction of the arrow 181 into the dust collector 190 under the action of gravity after being cooled. As shown in FIG. 6C, when the volatile is close to the gas barrier M3, under a blocking effect of the gas barrier M3, the volatile X3 drifts to the baffle plate 180 and is blocked by the baffle plate 180; since the circulating cooling water is being passed into the baffle plate 180, the temperature at the surface of the baffle plate 180 is low, then the volatile X3 may drop downwardly along the direction of the arrow 181 into the dust collector 190 under the action of gravity after being cooled. As the crystal growth process proceeds, a large amount of volatile powders may fall into the dust collector 190 as shown in FIG. 8, and slide down to the bottom of the dust collector 190 from a plurality of inclined plates due to the action of gravity sequentially, and due to the blocking effect of the plurality of inclined plates forming a zigzag, the powders can be prevented from floating out of the dust collector 190 again and entering into a chamber of a crystal growth furnace, which floats to a surface of a crystal and erodes the crystal.

Beneficial effects that may be brought about by some embodiments of the present disclosure include, but are not limited to:
(1) By utilizing the fact that it is necessary to introduce a required gas or inert gas in a process of industrial production (e.g., crystal growth) and adjusting an airflow direction (e.g., through a wind direction adjusting plate), a gas introduced forms a gas barrier in a vicinity of a window, henceforth preventing volatiles from adhering to an inner side of the window, keeping a surface of the window clean, and facilitating a better observation of a situation inside a furnace;
(2) By setting an air outlet on a baffle plate and adjusting the airflow direction using the wind direction adjusting plate, it is possible for an airflow to have both a clearing function and serve as a gas barrier;
(3) By setting a baffle having a cooling effect, an adjustable cross-sectional length, and a curved arc, and by setting a matching relationship between the angle θ₂ between the baffle plate and a window and the angle θ between the wind direction adjusting plate and the window (or the angle θ₂ between the baffle plate and the window and the angle θ₁ between the two sub-plates), and setting a set of sub-baffle-plates with an adjustable angle between each other and with a telescoping function, a blocking effect on volatiles or other gases can be better realized, and a flowing gas at the air outlet can be avoided from flowing directly into a heating zone of the industrial production (e.g., the crystal growth), which disturbs a stability of a temperature field;
(4) By installing a dust collector below the baffle plate, on an outer side below the baffle plate, or below the window, and using the baffle plate in combination with the dust collector, volatile powders can be collected in the dust collector, and deposited volatile powders can be prevented from floating inside a furnace chamber again and eroding the surface of the product (e.g., crystals);
(5) By setting an air intake port and an air intaking flow rate of the air intake port to be less than or equal to a discharging flow rate of an air discharging port, on the one hand, a stable circulating gas flow can be formed, a disturbance of the gas flowing to an interior of the furnace chamber can be minimized, and a stable furnace chamber environment can be maintained; on the other hand, for a gas needed for industrial production, the gas needed for industrial production can flow into the furnace chamber stably for a smooth progress of industrial production;
(6) By providing a plurality of downwardly inclined plates that are arranged in a zigzagging manner inside the dust collector, volatiles or other gaseous powders can be prevented from getting stuck on middle or the upper plates, which causes the volatiles or other gaseous powders to fall into the bottom of the dust collector, and also prevents the powders from floating out of the dust collector and into the furnace chamber again, where the powders may corrode the surface of the product (e.g., crystals).

## Claims

1. A window device (100) for a furnace (10), comprising:
a frame (120) configured to be placed in a sidewall of the furnace;
a window (110) placed on the frame;
an air inlet (130) placed on the frame; and
at least two air outlets (160), wherein,
the at least two air outlets (160) are configured to connect with the air inlet and an interior of the furnace; and
tangential directions of air venting pipelines at the at least two air outlets (160) are within a predetermined angle range; wherein the tangential directions of the air venting pipelines at the at least two air outlets (160) are referred to as a direction in which a tangent line of the air venting pipeline follows a flow of an airflow, the predetermined angle range is 10° to 170°;
at least two baffle plates (180) placed outside the at least two air outlets (160); and
one or more dust collectors (190) placed below an inner side of one of the at least two baffle plates (180) for collecting powder or other particulate matter that falls from an inner wall of the one of the at least two baffle plates (180).

2. The window device according to claim 1, wherein the at least two air outlets (160) are placed opposite along a circumference of the window.

3. The window device according to claim 1, wherein the at least two air outlets (160) are elongated or the at least two air outlets (160) are a set of circular air venting ports.

4. The window device according to claim 1, further comprising a wind direction adjusting plate (170), wherein the wind direction adjusting plate is placed outside the air outlet and wherein the at least two wind direction adjusting plates are used to adjust an airflow direction of a gas flowing from the at least two air outlets (160).

5. The window device according to claim 4, wherein the wind direction adjusting plate includes at least two sub-plates (171, 172).

6. The window device according to claim 5, wherein an angle between the sub-plates is adjustable, or the angle between the sub-plates is in a range of 10° to 65°.

7. The window device according to claim **1,** wherein the at least two baffle plates are placed along a circumference of the window and configured to be outside the furnace.

8. The window device according to claim 7, wherein an angle between each of the at least two baffle plates and the window is adjustable.

9. The window device according to claim 7, wherein the at least two baffle plates are curved.

10. The window device according to claim 7, wherein the at least two baffle plates include a set of sub-baffle-plates (180-1, 180-2) that an angle between the sub-baffle-plates is adjustable.

11. The window device according to claim 7, wherein the at least two air outlets (160) are respectively placed on the at least two baffle plates and face the window.

12. The window device according to claim 7, further comprising an air intake port (131), wherein the air intake port is placed on one of the at least two baffle plates.

13. The window device according to claim 1, further comprising: at least two inclined plates (191, 192, 193, 194, 195) placed inside the one or more dust collectors.

14. The window device according to claim 1, further comprising:
a water inlet (140) and a water outlet (150) placed on an outer side of the frame, the water inlet and the water outlet forming a cooling channel across the window device.

15. The window device according to claim 11, wherein the air intake port (131) is coupled to a pumping device via a pipeline to pump an airflow from the air outlet (160).

## Patentansprüche

1. Fenstervorrichtung (100) für einen Ofen (10), umfassend:
einen Rahmen (120), der dazu konfiguriert ist, in einer Seitenwand des Ofens platziert zu sein;
ein an dem Rahmen platziertes Fenster (110);
einen an dem Rahmen platzierten Lufteinlass (130); und
mindestens zwei Luftauslässe (160), wobei
die mindestens zwei Luftauslässe (160) dazu konfiguriert sind, mit dem Lufteinlass und einem Inneren des Ofens verbunden zu sein; und
Tangentenrichtungen von Entlüftungsleitungen an den mindestens zwei Luftauslässen (160) innerhalb eines vorbestimmten Winkelbereichs liegen; wobei die Tangentenrichtungen der Entlüftungsleitungen an den mindestens zwei Luftauslässen (160) als eine Richtung bezeichnet werden, in der eine Tangente der Entlüftungsleitung einem Luftstrom folgt, wobei der vorbestimmte Winkelbereich 10° bis 170° beträgt;
mindestens zwei Prallplatten (180), die außerhalb der mindestens zwei Luftauslässe (160) platziert sind; und
einen oder mehrere Staubsammler (190), die unter einer Innenseite einer der mindestens zwei Prallplatten (180) platziert sind, um Pulver oder andere Partikel zu sammeln, die von einer Innenwand der einen der mindestens zwei Prallplatten (180) fallen.

2. Fenstervorrichtung nach Anspruch 1, wobei die mindestens zwei Luftauslässe (160) entlang eines Umfangs des Fensters entgegengesetzt platziert sind.

3. Fenstervorrichtung nach Anspruch 1, wobei die mindestens zwei Luftauslässe (160) länglich sind oder die mindestens zwei Luftauslässe (160) ein Satz kreisförmiger Entlüftungsöffnungen sind.

4. Fenstervorrichtung nach Anspruch 1, die weiter eine Windrichtungs-Einstellplatte (170) umfasst, wobei die Windrichtungs-Einstellplatte außerhalb des Luftauslasses platziert ist und wobei die mindestens zwei Windrichtungs-Einstellplatten dazu verwendet werden, eine Luftstromrichtung eines aus den mindestens zwei Luftauslässen (160) strömenden Gases einzustellen.

5. Fenstervorrichtung nach Anspruch 4, wobei die Windrichtungs-Einstellplatte mindestens zwei Teilplatten (171, 172) einschließt.

6. Fenstervorrichtung nach Anspruch 5, wobei ein Winkel zwischen den Teilplatten einstellbar ist oder der Winkel zwischen den Teilplatten in einem Bereich von 10° bis 65° liegt.

7. Fenstervorrichtung nach Anspruch 1, wobei die mindestens zwei Prallplatten entlang eines Umfangs des Fensters platziert sind und dazu konfiguriert sind, sich außerhalb des Ofens zu befinden.

8. Fenstervorrichtung nach Anspruch 7, wobei ein Winkel zwischen jeder der mindestens zwei Prallplatten und dem Fenster einstellbar ist.

9. Fenstervorrichtung nach Anspruch 7, wobei die mindestens zwei Prallplatten gekrümmt sind.

10. Fenstervorrichtung nach Anspruch 7, wobei die mindestens zwei Prallplatten einen Satz von Teilprallplatten (180-1, 180-2) einschließen, wobei ein Winkel zwischen den Teilprallplatten einstellbar ist.

11. Fenstervorrichtung nach Anspruch 7, wobei die mindestens zwei Luftauslässe (160) jeweils auf den mindestens zwei Prallplatten platziert sind und dem Fenster zugewandt sind.

12. Fenstervorrichtung nach Anspruch 7, die weiter eine Lufteinlassöffnung (131) umfasst, wobei die Lufteinlassöffnung an einer der mindestens zwei Prallplatten platziert ist.

13. Fenstervorrichtung nach Anspruch 1, die weiter umfasst: mindestens zwei geneigte Platten (191, 192, 193, 194, 195), die innerhalb des einen oder der mehreren Staubsammler platziert sind.

14. Fenstervorrichtung nach Anspruch 1, weiter umfassend:
einen Wassereinlass (140) und einen Wasserauslass (150), die an einer Außenseite des Rahmens platziert sind, wobei der Wassereinlass und der Wasserauslass einen Kühlkanal über die Fenstervorrichtung bilden.

15. Fenstervorrichtung nach Anspruch 11, wobei die Lufteinlassöffnung (131) über eine Leitung an eine Pumpvorrichtung gekoppelt ist, um einen Luftstrom aus dem Luftauslass (160) zu pumpen.

## Revendications

1. Dispositif de fenêtre (100) pour un four (10), comprenant :
un cadre (120) configuré pour être placé dans une paroi latérale du four ;
une fenêtre (110) placée sur le cadre ;
un orifice d'entrée d'air (130) placé sur le cadre ; et
au moins deux orifices de sortie d'air (160), dans lequel,
les au moins deux orifices de sortie d'air (160) sont configurés pour être raccordés à l'orifice d'entrée d'air et à l'intérieur du four ; et
des directions tangentielles des conduites d'évacuation d'air au niveau des au moins deux orifices de sortie d'air (160) sont comprises dans une plage d'angle prédéterminée ; dans lequel les directions tangentielles des conduites d'évacuation d'air au niveau des au moins deux orifices de sortie d'air (160) sont appelées une direction dans laquelle une ligne tangente de la conduite d'évacuation d'air suit une circulation d'un flux d'air, la plage d'angle prédéterminée est 10° à 170° ;
au moins deux plaques déflectrices (180) placées à l'extérieur des au moins deux orifices de sortie d'air (160) ; et
un ou plusieurs collecteurs de poussière (190) placés sous un côté interne d'une des au moins deux plaques déflectrices (180) pour collecter de la poudre ou d'autres matières particulaires qui tombent d'une paroi interne de l'une des au moins deux plaques déflectrices (180).

2. Dispositif de fenêtre selon la revendication 1, dans lequel les au moins deux orifices de sortie d'air (160) sont placés à l'opposé le long d'une circonférence de la fenêtre.

3. Dispositif de fenêtre selon la revendication 1, dans lequel les au moins deux orifices de sortie d'air (160) sont allongés ou les au moins deux orifices de sortie d'air (160) sont un ensemble d'orifices d'aération d'air circulaires.

4. Dispositif de fenêtre selon la revendication 1, comprenant en outre une plaque d'ajustement de la direction du vent (170), dans lequel la plaque d'ajustement de la direction du vent est placée à l'extérieur de l'orifice de sortie d'air et dans lequel les au moins deux plaques d'ajustement de la direction du vent sont utilisées pour ajuster une direction de flux d'air d'un gaz circulant à partir des au moins deux orifices de sortie d'air (160).

5. Dispositif de fenêtre selon la revendication 4, dans lequel la plaque d'ajustement de la direction du vent inclut au moins deux sous-plaques (171, 172).

6. Dispositif de fenêtre selon la revendication 5, dans lequel un angle entre les sous-plaques est ajustable, ou l'angle entre les sous-plaques est dans une plage de 10° à 65°.

7. Dispositif de fenêtre selon la revendication 1, dans lequel les au moins deux plaques déflectrices sont placées le long d'une circonférence de la fenêtre et configurées pour être à l'extérieur du four.

8. Dispositif de fenêtre selon la revendication 7, dans lequel un angle entre chacune des au moins deux plaques déflectrices et la fenêtre est ajustable.

9. Dispositif de fenêtre selon la revendication 7, dans lequel les au moins deux plaques déflectrices sont incurvées.

10. Dispositif de fenêtre selon la revendication 7, dans lequel les au moins deux plaques déflectrices incluent un ensemble de sous-plaques déflectrices (180-1, 180-2) de telle sorte qu'un angle entre les sous-plaques déflectrices soit ajustable.

11. Dispositif de fenêtre selon la revendication 7, dans lequel les au moins deux orifices de sortie d'air (160) sont respectivement placés sur les au moins deux plaques déflectrices et font face à la fenêtre.

12. Dispositif de fenêtre selon la revendication 7, comprenant en outre un orifice d'admission d'air (131), dans lequel l'orifice d'admission d'air est placé sur l'une des au moins deux plaques déflectrices.

13. Dispositif de fenêtre selon la revendication 1, comprenant en outre : au moins deux plaques inclinées (191, 192, 193, 194, 195) placées à l'intérieur des un ou plusieurs collecteurs de poussières.

14. Dispositif de fenêtre selon la revendication 1, comprenant en outre :
un orifice d'entrée d'eau (140) et un orifice de sortie d'eau (150) placés sur un côté externe du cadre, l'orifice d'entrée d'eau et l'orifice de sortie d'eau formant un canal de refroidissement à travers le dispositif de fenêtre.

15. Dispositif de fenêtre selon la revendication 11, dans lequel l'orifice d'admission d'air (131) est couplé à un dispositif de pompage au moyen d'une canalisation pour pomper un flux d'air depuis l'orifice de sortie d'air (160).
